# EUROPÄISCHE PATENTSCHRIFT

(11) **EP 3 803 367 B1**
(45) Veröffentlichungstag und Bekanntmachung des Hinweises auf die Patenterteilung: **13.09.2023**
(21) Anmeldenummer: 19727671.0
(22) Anmeldetag: 29.05.2019
(51) Int. Cl.: G01N 27/622, H01J 49/06, H05K 1/14

(54) **IONENTRANSPORTVORRICHTUNG, IONENMOBILITÄTSSPEKTROMETER UND IONENTRICHTER**
ION TRANSPORT DEVICE, ION MOBILITY SPECTROMETER AND ION FUNNEL
DISPOSITIF DE TRANSPORT IONIQUE, SPECTROMÈTRE DE MOBILITÉ IONIQUE ET ENTONNOIR À IONS

(30) Priorität: 05.06.2018 DE 102018113331
(43) Veröffentlichungstag der Anmeldung: 14.04.2021
(73) Patentinhaber: Gottfried Wilhelm Leibniz Universität Hannover, 30167 Hannover (DE)
(72) Erfinder: ZIMMERMANN, Stefan, 30938 Burgwedel (DE); KIRK, Ansgar, 30419 Hannover (DE); BOHNHORST, Alexander, 30449 Hannover (DE)
(74) Vertreter: Kröncke, Rolf
(86) Internationale Anmeldenummer: PCT/EP2019/064029
(87) Internationale Veröffentlichungsnummer: WO 2019/233865

(56) Entgegenhaltungen:
- US-A1- 2015 318 156
- US-A1- 2017 236 698
- US-B1- 6 316 768
- BOHNHORST A ET AL: "Simulation aided design of a low cost ion mobility spectrometer based on printed circuit boards", INTERNATIONAL JOURNAL FOR ION MOBILITY SPECTROMETRY, SPRINGER, DE, Bd. 19, Nr. 2, 4. Juni 2016 (2016-06-04), Seiten 167-174, XP036051555, ISSN: 1435-6163, DOI: 10.1007/S12127-016-0202-7 [gefunden am 2016-06-04]
- GARY A. EICEMAN ET AL: "Planar Drift Tube for Ion Mobility Spectrometry", INSTRUMENTATION SCIENCE & TECHNOLOGY, Bd. 35, Nr. 4, 2. Juli 2007 (2007-07-02), Seiten 365-383, XP055611314, US ISSN: 1073-9149, DOI: 10.1080/10739140701436520

## Beschreibung

Die Erfindung betrifft eine lonentransportvorrichtung, die zum Transport von Ionen mittels eines elektrischen Feldes eingerichtet ist, wobei die lonentransporteinrichtung einen lonentransportkanal aufweist, in dem eine Ionentransportkammer gebildet ist, wobei die Ionentransporteinrichtung zur Erzeugung des elektrischen Feldes eine Vielzahl von Felderzeugungselektroden aufweist, die entlang der Längserstreckung des Ionentransportkanals hintereinander angeordnet sind, um Ionen in einer Transportrichtung durch die Ionentransportkammer zu bewegen. Die Erfindung betrifft außerdem ein lonenmobilitätsspektrometer sowie ein Massenspektrometer.

Ionenmobilitätsspektrometer (IMS) sind Geräte zur schnellen und sensitiven Spurengasanalyse, die Ionen anhand ihrer Bewegung durch ein neutrales Driftgas unter dem Einfluss eines elektrischen Driftfeldes voneinander separieren. Diese Separation der Ionen findet in der sogenannten Driftröhre des IMS statt, in der über entsprechende Elektroden das Driftfeld erzeugt wird. Für eine definierte Umgebung kann die Driftröhre mit einem Driftgas durchspült und gegenüber der Umgebung hermetisch verschlossen sein, um einen Eintrag von Verunreinigungen aus der Umgebung zu verhindern. Das elektrische Potential der einzelnen Driftelektroden, die zur Erzeugung des Driftfeldes dienen, kann beispielsweise über einen resistiven Spannungsteiler eingestellt werden. Dementsprechend ist die Driftröhre, welche den Driftraum definiert, neben dem Ionisationsraum bzw. Reaktionsraum und dem Detektor eine der Hauptkomponenten eines lonenmobilitätsspektrometers.

Beim Einlass eines Massenspektrometers (MS) liegen teilweise ähnliche Erfordernisse vor, d.h. auch dort sollen Ionen durch ein elektrisches Feld durch eine Kammer transportiert werden. Daher wird nachfolgend verallgemeinernd von einer Ionentransporteinrichtung gesprochen, die bei einem IMS die Driftröhre und bei einem Massenspektrometer den Ionentrichter (Funnel) bilden kann.

Aus der Veröffentlichung Bohnhorst A. et al.: "Stimulations aided design of a low cost ion mobility spectrometer based on printed circuit boards", International Journal for Ion Mobility Spectrometry, Springer, DE, Bd. 19, Nr. 2, 4. Juni 2016, Seiten 167-174 geht ein lonenmobilitätsspektrometer hervor. Aus der US 6,316,768 B1 geht die Nutzung von Leiterplatten als Isolationskomponenten für ein Ionenmassenspektrometer hervor. Aus der US 2017/0236698 A1 gehen ein ionenoptischer Apparat und ein Ionenmassenspektrometer hervor.

Die Bereitstellung von lonenmobilitätsspektrometern und Massenspektrometern ist derzeit noch mit hohem produktionstechnischen Aufwand verbunden. Der Erfindung liegt die Aufgabe zugrunde, Lösungen anzugeben, mit denen solche Geräte mit geringerem Aufwand hergestellt werden können.

Die Aufgabe wird gelöst durch eine Ionentransporteinrichtung der eingangs genannten Art, mit folgenden Merkmalen:
a) der Ionentransportkanal weist mehrere aus ebenen Platten gebildete Seitenwände auf, die die Ionentransportkammer umgeben,
b) die Seitenwände sind aus mit wenigstens einer ersten Leiterschicht beschichteten elektrischen Leiterplatten gebildet,
c) die Felderzeugungselektroden sind als unterbrochene Ringelektroden ausgebildet, die die Ionentransportkammer umfangsseitig umgeben, wobei eine, mehrere oder alle der Ringelektroden jeweils aus einzelnen, auf den Leiterplatten durch einen Teil der ersten Leiterschicht gebildeten Leiterbahn-Segmenten zusammengesetzt sind, wobei Leiterbahn-Segmente einer Ringelektrode sich elektrisch kontaktieren können, aber nicht notwendigerweise elektrisch kontaktieren müssen,
d) die Ionentransporteinrichtung weist wenigstens einen ersten Spannungsteiler mit einer Vielzahl von Spannungsteiler-Anschlusspunkten und wenigstens einen zweiten Spannungsteiler mit einer Vielzahl von Spannungsteiler-Anschlusspunkten auf,
e) wobei für eine, mehrere oder alle der Ringelektroden gilt:
   e1) wenigstens ein Leiterbahn-Segment der Ringelektrode ist an einen Spannungsteiler-Anschlusspunkt des ersten Spannungsteilers angeschlossen,
   e1) wenigstens ein anderes Leiterbahn-Segment der Ringelektrode als das Leiterbahn-Segment, das an den Spannungsteiler-Anschlusspunkt des ersten Spannungsteilers angeschlossen ist, ist an einen Spannungsteiler-Anschlusspunkt des zweiten Spannungsteilers angeschlossen.

Die Erfindung hat den Vorteil, dass die Ionentransporteinrichtung mit einfachen und kostengünstig bereitstellbaren Komponenten, nämlich mit handelsüblichen Leiterplatten, bereitgestellt werden kann. Hierbei können insbesondere die Seitenwände des Ionentransportkanals durch Leiterplatten gebildet werden, in nachfolgend noch erläuterten Weiterbildungen können auch weitere Elemente eines IMS oder eines MS durch Leiterplatten gebildet werden, sodass sich der Gesamtaufwand der Herstellung weiter verringert. Die Leiterplatten können dabei in üblicher Weise, wie es von Leiterplatten für elektronische Schaltungen bekannt ist, hergestellt und in die gewünschte Form gebracht werden, z.B. durch Fräsen, Ätzen oder anderweitige Form-Bearbeitung. Die Leiterplatten können als einlagige oder mehrlagige Leiterplatten ausgebildet sein, d.h. sie können eine oder mehrere Leiterschichten aufweisen. Vorteilhafter Weise ist zumindest eine Leiterschicht vorhanden, nämlich die zuvor erwähnte erste Leiterschicht. Diese Leiterschicht wird genutzt, um die Ringelektroden zu bilden. Es wurde herausgefunden, dass die Ringelektroden nicht notwendiger Weise, wie es bisher üblich war, eine kreisrunde Ringform aufweisen müssen. Auch eine rechteckige, quadratische oder sonstige mehreckige Querschnittsform, wie sie aus zusammengesetzten ebenen Platten gebildet werden kann, eignet sich in gleicher Weise. Die Ringelektroden können somit direkt durch Segmente der Leiterschichten gebildet werden, es müssen keine sonstigen zusätzlichen Bauteile zur Bildung der Ringelektroden montiert bzw. angelötet werden.

Erfindungsgemäß ist der Ionentransportkanal somit aus einzelnen (zunächst separaten) elektrischen Leiterplatten aufgebaut, die die Seitenwände des Ionentransportkanals bilden. Diese einzelnen elektrischen Leiterplatten sind an Verbindungsstellen miteinander verbunden. Die Verbindungsstellen, an denen die einzelnen Leiterplatten gefügt sind, können dabei gasdicht ausgebildet sein. In einer vorteilhaften Ausgestaltung der Erfindung sind die einzelnen elektrischen Leiterplatten, die die Seitenwände bilden (und ggf. auch die nachfolgend erläuterten weiteren Teile des Ionentransportkanals), als starre Leiterplatten ausgebildet. Dies hat den Vorteil, dass durch die zusammengefügten Leiterplatten bereits eine selbsttragende Struktur gebildet werden kann, die die Ionentransportkanal bildet.

Durch die erläuterte Leiterplatten-Bauweise der Ionentransporteinrichtung können kompaktbauende Driftröhren oder Ionentrichter hergestellt werden, wie sie insbesondere für Hand-held-Geräte notwendig sind. Zudem kann auf einfache Weise eine hohe Anzahl dünner und schmaler Ringelektroden bereitgestellt werden, um die benötigte Homogenität des elektrischen Driftfeldes zu erreichen. Dies ist mit handelsüblichen Leiterplatten auf einfache Weise realisierbar. Zudem lassen sich Leiterplatten mittels Standardverfahren der Industrie fertigen und somit sehr kostengünstig herstellen. Durch die erfindungsgemäße Leiterplatten-Bauweise können auch Ionentransporteinrichtungen für IMS bereitgestellt werden, die mit Unterdruck und hohen elektrischen Feldstärken betrieben werden.

Die Ionentransporteinrichtung kann z.B. den gesamten Bereich zwischen Ionenquelle und Ionendetektor umfassen, d.h. sämtliche Bereiche, durch die Ionen transportiert werden können, wie Ionisationsraum, Ionentor, Driftraum, Detektorbereich, d.h. Raum zwischen Aperturgitter (Abschluss der Driftröhre) und Detektor.

Der Ionentransportkanal kann z.B. nur ein Teil der Ionentransporteinrichtung sein, z.B. ein Segment in Längsrichtung der Ionentransporteinrichtung, wie nachfolgend noch erläutert wird.

Vorteilhafter Weise weisen die verwendeten Leiterplatten, die die Seitenwände bilden, bereits Anschlusspunkte für einen ersten und einen zweiten Spannungsteiler auf, sodass die für die Erzeugung des gleichmäßigen elektrischen Feldes erforderlichen Bauteile zur Bildung des Spannungsteilers in einfacher Weise kontaktierbar sind. Zudem kann hierdurch die Montage der Seitenwände vereinfacht werden, da nicht zwangsläufig eine elektrische Kontaktierung zwischen sämtlichen Leiterbahn-Segmenten einer Ringelektrode erforderlich ist. Dementsprechend werden keine elektrischen Kontaktierungen zwischen den Seitenwänden benötigt.

Der erste und/oder der zweite Spannungsteiler kann z.B. als Reihenschaltung von Widerständen, als kontinuierliche Widerstandsbahn oder als Kombination daraus ausgebildet sein.

Die Ionentransporteinrichtung kann grundsätzlich eine beliebige Anzahl von Seitenwänden im Bereich von drei bis unendlich aufweisen. Fertigungstechnisch besonders günstig ist die Anordnung von vier Seitenwänden, z.B. mit quadratischem oder rechteckigem Querschnitt des Ionentransportkanals. Aber auch andere Zahlen von Seitenwänden, z.B. drei, fünf, sechs, sieben, acht, können in manchen Anwendungsfällen vorteilhaft sein.

Die auf einer Leiterplatte angeordneten Leiterbahn-Segmente können vorteilhaft in gleichmäßigen Abständen zueinander angeordnet sein. Es ist ebenfalls vorteilhaft, wenn die Leiterbahn-Segmente einer Leiterplatte jeweils gleiche Breiten haben.

Gemäß einer vorteilhaften Weiterbildung der Erfindung ist vorgesehen, dass eine, mehrere oder alle Seitenwände wenigstens eine parallel zur ersten Leiterschicht verlaufende zweite Leiterschicht der elektrischen Leiterplatte aufweisen. Dementsprechend können mehrlagige Leiterplatten eingesetzt werden, wodurch die auf den einzelnen Leiterplatten bzw. den Seitenwänden realisierbare Funktionalität erhöht werden kann. Der Einsatz mehrlagiger Leiterplatten bietet zudem die Möglichkeit, zusätzliche Elektronik direkt in die Ionentransporteinrichtung zu integrieren. Die erste Leiterschicht kann eine an der Oberfläche der Leiterplatte oder im Leiterplattenmaterial angeordnete Leiterschicht sein. Die zweite Leiterschicht kann eine an der anderen Oberfläche der Leiterplatte angeordnete Leiterschicht oder eine im Leiterplattenmaterial angeordnete Leiterschicht sein.

Die zweite Leiterschicht oder eine zusätzlich vorgesehene Leiterschicht kann zudem eine Abschirmung der Anordnung bilden, sodass die Störfestigkeit erhöht werden kann.

Hierbei ist es vorteilhaft, wenn die Leiterplatte zumindest auf der Seite, an der die erste Leiterschicht angeordnet ist, ohne zusätzliche Beschichtungen wie Lötstopplack oder ähnliches ausgebildet ist. Hierdurch kann eine unerwünschte Beeinflussung der Sensitivität der Ionentransporteinrichtung vermieden werden.

Gemäß einer vorteilhaften Weiterbildung der Erfindung ist vorgesehen, dass der erste und/oder der zweite Spannungsteiler auf der zweiten Leiterschicht angeordnet ist. Dies hat den Vorteil, dass die den ersten und/oder zweiten Spannungsteiler bildenden Bauteile sozusagen vor Ort angeordnet werden können, d.h. dort, wo sich auch die Ringelektroden befinden, sodass unnötig lange Zuleitungen vermieden werden können.

Gemäß einer vorteilhaften Weiterbildung der Erfindung ist vorgesehen, dass der erste Spannungsteiler mehreren Seitenwänden und/oder der zweite Spannungsteiler mehreren Seitenwänden zugeordnet ist. Auf diese Weise kann die Anzahl der erforderlichen Spannungsteiler minimiert werden. Der erste Spannungsteiler kann dadurch mehreren Seitenwänden einer Ringelektrode zugeordnet sein. Der zweite Spannungsteiler kann dadurch mehreren Seitenwänden einer Ringelektrode zugeordnet sein. Die gesamte Ionentransporteinrichtung kann beispielsweise mit nur zwei Spannungsteilern realisiert werden.

Gemäß einer vorteilhaften Weiterbildung der Erfindung ist vorgesehen, dass der erste Spannungsteiler einer ersten Seitenwand und/oder der zweite Spannungsteiler einer zweiten Seitenwand zugeordnet ist. Dies hat den Vorteil, dass jeder Seitenwand einzelne, individuelle Spannungsteiler zugewiesen sind, sodass unerwünschte Querbeeinflussungen vermieden werden.

Gemäß einer vorteilhaften Weiterbildung der Erfindung ist vorgesehen, dass jeder aus einer Leiterplatte gebildeten Seitenwand ein eigener Spannungsteiler zugeordnet ist. Auf diese Weise wird der Verbindungsaufwand zwischen den einzelnen Segmenten der Ringelektrode minimiert.

Gemäß einer vorteilhaften Weiterbildung der Erfindung ist vorgesehen, dass die Ionentransporteinrichtung ein Netzwerk von Koppelkondensatoren aufweist, durch das die Ringelektroden mit einer elektrischen Signalquelle verbindbar sind, wobei einer, mehrere oder alle der Koppelkondensatoren durch Teile von Leiterschichten einer oder mehrerer aus einer Leiterplatte gebildeten Seitenwänden gebildet sind. Dies hat den Vorteil, dass ein Funnel für ein MS besonders einfach und kostengünstig bereitgestellt werden kann. Die für diese Anwendung erforderlichen Koppelkondensatoren können somit direkt durch Leiterschichten der Leiterplatten gebildet werden, so dass der Einbau diskreter Bauteile weitgehend minimiert werden kann.

Gemäß einer vorteilhaften Weiterbildung der Erfindung ist vorgesehen, dass die Ionentransporteinrichtung wenigstens einen Heizdraht zum Aufheizen des Ionentransportkanals aufweist, wobei der Heizdraht durch Teile von Leiterschichten einer oder mehrerer aus einer Leiterplatte gebildeten Seitenwänden gebildet ist. Dies hat den Vorteil, dass keine gesonderten Bauteile zur Bildung einer Heizeinrichtung erforderlich sind. Vielmehr kann der notwendige Heizdraht direkt durch Teile von Leiterschichten auf einer oder mehreren Leiterplatten ausgebildet werden. Der Heizdraht kann z.B. durch einen mäanderförmigen Verlauf einer Leiterschicht auf einer Leiterplatte oder mehreren Leiterplatten gebildet werden.

Gemäß einer vorteilhaften Weiterbildung der Erfindung ist vorgesehen, dass ein Teil oder alle der Felderzeugungselektroden auf den Innenlagen der Leiterplatten realisiert wird. Dies hat den Vorteil, dass sich die Anzahl der Felderzeugungselektroden pro Längeneinheit weiter erhöhen lässt. Insbesondere können auf diese Weise Segmente der Ringelektroden durch Innenlagen der Leiterplatten realisiert werden. Als Innenlagen der Leiterplatten sind dabei solche Leiterschichten anzusehen, die nicht an den Außenoberflächen liegen, sondern zwischen den äußeren Leiterschichten.

Gemäß einer vorteilhaften Weiterbildung der Erfindung ist vorgesehen, dass die Ionentransporteinrichtung einen Ionendetektor aufweist, der an einem Ende des Ionentransportkanals angeordnet ist, wobei der Ionendetektor durch eine Leiterschicht einer Leiterplatte oder durch ein geätztes Metallgitter, das durch wenigstens eine Leiterplatte sowohl mechanisch fixiert als auch elektrisch kontaktiert ist, gebildet ist. Dies hat den Vorteil, dass die Bereitstellung der Ionentransporteinrichtung weiter vereinfacht wird, da auch für die Bereitstellung des erforderlichen Ionendetektors keine zusätzlichen, komplizierten Bauteile erforderlich sind. Vielmehr kann auch der Ionendetektor durch eine Leiterschicht einer Leiterplatte gebildet sein, z.B. einer Leiterplatte, die als Abschlussplatte des Ionentransportkanals daran befestigt ist. Alternativ kann der Ionendetektor oder wahlweise auch eine, mehrere oder alle der nachfolgend genannten Elektroden als ein solches geätztes Metallgitter ausgebdildet sein. Vorteilhafterweise wird das geätzte Metallgitter durch Leiterplatten sowohl mechanisch fixiert als auch elektrisch kontaktiert.

Gemäß einer vorteilhaften Weiterbildung der Erfindung ist vorgesehen, dass die Ionentransporteinrichtung an mindestens einem Ende des Ionentransportkanals ein Ionentor aufweist, wobei zumindest eine Elektrode des Ionentors durch eine Leiterschicht einer Leiterplatte oder durch ein geätztes Metallgitter, das durch wenigstens eine Leiterplatte sowohl mechanisch fixiert als auch elektrisch kontaktiert ist, gebildet ist. Dies hat den Vorteil, dass die Bereitstellung der Ionentransporteinrichtung weiter vereinfacht wird, da auch für die Bereitstellung des erforderlichen Ionentors keine zusätzlichen, komplizierten Bauteile erforderlich sind. Vielmehr kann auch das Ionentor oder zumindest ein Teil davon durch eine Leiterschicht einer Leiterplatte gebildet sein, z.B. einer Leiterplatte, die als Abschlussplatte des Ionentransportkanals daran befestigt ist.

Gemäß einer vorteilhaften Weiterbildung der Erfindung ist vorgesehen, dass wenigstens eine der Leiterplatten wenigstens eine nutartige Aussparung aufweist, in die wenigstens eine andere Leiterplatte formschlüssig eingesetzt ist. Dies hat den Vorteil, dass die Ionentransporteinrichtung aus den einzelnen Leiterplatten besonders einfach zusammensetzbar ist, da durch die nutartige Aussparung formschlüssige Verbindungsmittel bereitgestellt werden, die das Zusammensetzen der Bauteile und die Befestigung aneinander vereinfachen.

Die einzelnen Leiterplatten, aus denen die Ionentransporteinrichtung zusammengesetzt ist, können z.B. mit Klebstoff oder Lot kraftschlüssig, formschlüssig oder reibschlüssig miteinander verbunden werden. Beim mechanischen Verbinden durch Lot können z.B. Teile von Leiterschichten genutzt werden, um Befestigungspunkte zu bilden.

Gemäß einer vorteilhaften Weiterbildung der Erfindung ist vorgesehen, dass die durch Leiterbahnen-Segmente gebildeten Ringelektroden als mehreckige Ringelektroden ausgebildet sind, deren Anzahl der Ecken der Anzahl der Seitenwände entspricht. Übliche Ringelektroden von IMS oder MS sind als geschlossene kreisringförmige elektrisch leitende Strukturen ausgebildet. Derartige Elektrodenstrukturen sind mit Leiterplatten jedoch schwer herzustellen. Der hier vorgeschlagene Aufbau teilt jede Ringelektrode in mehrere Segmente ein, die sich plan auf den Leiterplatten befinden, da sie gleichzeitig auch die Wandungen des Ionentransportkanals bilden. Hierdurch können die Segmente aller Ringelektroden auf jeweils einer Leiterplatte platziert werden, was den Aufwand bei der Herstellung massiv verringert. Je nach Anordnung und Anzahl der Leiterplatten entstehen verschiedene Formen von Ring-elektroden, wie dreieckige, viereckige, insbesondere rechteckige oder quadratische, oder mehreckige Ringelektroden. Es hat sich gezeigt, dass durch eine solche Formgebung der Ringelektroden die Performance eines IMS oder MS nicht verschlechtert wird.

Gemäß einer vorteilhaften Weiterbildung der Erfindung ist vorgesehen, dass das Verhältnis von Breite zu Höhe (= Dicke der Leiterschicht) eines Leiterbahn-Segments einer Ringelektrode größer 1 ist, insbesondere größer 5 ist. Hierdurch kann eine hohe Effizienz der Ringelektroden bei der Ausbildung eines homogenen elektrischen Feldes realisiert werden. Zudem werden durch die Leiterbahn-Segmente nur wenig störende Kapazitäten erzeugt.

Gemäß einer vorteilhaften Weiterbildung der Erfindung ist vorgesehen, dass das Verhältnis von Breite zu lateralem Abstand von benachbarten Leiterbahn-Segmenten benachbarter Ringelektroden größer 0,5 ist, insbesondere größer 1 oder größer 3 ist. Hierdurch kann eine hohe Effizienz der Ringelektroden bei der Ausbildung eines homogenen elektrischen Feldes realisiert werden.

Gemäß einer vorteilhaften Weiterbildung der Erfindung ist vorgesehen, dass die Ionentransporteinrichtung in Transportrichtung in Segmente segmentiert ist. Durch die Segmente, die auch als Längssegmente bezeichnet werden können, kann beispielsweise ein modularer Aufbau der Ionentransporteinrichtung in Längsrichtung realisiert werden. Ein Segment der Ionentransporteinrichtung kann z.B. die Driftröhre sein, ein weiteres Segment kann der Reaktionsraum sein. Eines, mehrere oder alle Segmente können jeweils durch den erfindungsgemäß in Leiterplatten-Bauweise aufgebauten Ionentransportkanal gebildet sein, insbesondere die Driftröhre.

Gemäß einer vorteilhaften Weiterbildung der Erfindung ist vorgesehen, dass eines, mehrere oder alle Segmente der Ionentransporteinrichtung jeweils von wenigstens einer senkrecht zur Transportrichtung angeordneten Abschlussplatte abgeschlossen ist, die als Leiterplatte ausgebildet ist. Durch solche Abschlussplatten kann einerseits ein gasdichter endseitiger Abschluss des Segments realisiert werden. Zudem können durch solche Abschlussplatten noch andere Funktionalitäten realisiert werden, wie z.B. ein Ionentor und/oder einen Ionendetektor.

Die Abschlussplatten können somit das Interface zwischen Driftraum und einem der oben genannten Segmente bilden, d.h. auf eine Abschlussplatte kann ein Ionentor, Ionisationsraum bzw. Reaktionsraum, Detektor oder ein weiterer Driftraum folgen. Gleiches gilt für die anderen Segmente. So können die Abschlussplatten z.B. einen Wechsel zwischen horizontaler und vertikaler Ausrichtung der Leiterplatten darstellen.

Gemäß einer vorteilhaften Weiterbildung der Erfindung ist vorgesehen, dass eine, mehrere oder alle Abschlussplatten in Umfangsrichtung über wenigstens eine der Seitenwände hinausragen. Hierdurch wird die Befestigung der Seitenwände an den Abschlussplatten vereinfacht. Beispielsweise kann in einer Abschlussplatte eine ringförmige Nut angeordnet sein, die der Querschnittform der Anordnung aus den Seitenwänden des Ionentransportkanals entspricht. Der Ionentransportkanal kann dann in diese Nut eingesteckt und darin befestigt werden. Dies erlaubt eine einfache formschlüssige Befestigung des Ionentransportkanals an einer Abschlussplatte, wobei eine hohe Stabilität und gute Dichtigkeit realisiert werden kann.

Gemäß einer vorteilhaften Weiterbildung der Erfindung ist vorgesehen, dass zwischen benachbarten Segmenten der Ionentransporteinrichtung wenigstens eine Elektrode angeordnet ist, die durch eine Leiterschicht einer Leiterplatte oder durch ein geätztes Metallgitter, das durch wenigstens eine Leiterplatte sowohl mechanisch fixiert als auch elektrisch kontaktiert ist, gebildet ist. Eine solche Elektrode kann z.B. die Elektrode eines Ionentors sein. So kann beispielsweise ein Ionentor mit zwei Gitterelektroden gebildet werden, indem beispielsweise eine beidseitig mit Leiterschichten beschichtete Leiterplatte eingesetzt wird, wobei die Leiterschichten die Gitterelektroden bilden kann. Es können auch zwei geätzte Metallgitter eingesetzt werden, die durch eine Leiterplatte sowohl mechanisch fixiert als auch elektrisch kontaktiert werden.

Gemäß einer vorteilhaften Weiterbildung der Erfindung ist vorgesehen, dass die Seitenwände auf die Ionentransportkammer gasdicht umgeben. Auf diese Weise kann bereits durch die Seitenwände die erforderliche hermetische Dichtung eines IMS realisiert werden. Alternativ ist es möglich, die Seitenwände nicht hermetisch abzudichten und stattdessen die Ionentransporteinrichtung oder das damit ausgerüstete IMS oder den Ionentrichter in einer gasdichten Umhausung anzuordnen.

Die eingangs genannte Aufgabe wird außerdem gelöst durch ein lonenmobilitätsspektrometer mit einer Ionentransporteinrichtung der zuvor erläuterten Art. Der Ionentransportkanal kann dabei die Driftröhre des lonenmobilitätsspektrometers bilden. Der Ionentransportkanal kann auch den Reaktionsraum oder eines der oben genannten Segmente des lonenmobilitätsspektrometers bilden. Auch hierdurch können die zuvor erläuterten Vorteile realisiert werden.

Die eingangs genannte Aufgabe wird außerdem gelöst durch ein Massenspektrometer mit einer Ionentransporteinrichtung der zuvor erläuterten Art. Der Ionentransportkanal kann dabei den Ionentrichter des Massenspektrometers bilden. Auch hierdurch können die zuvor erläuterten Vorteile realisiert werden.

Die Erfindung wird nachfolgend anhand von Ausführungsbeispielen unter Verwendung von Zeichnungen näher erläutert.

Es zeigen
- Figur 1: ein lonenmobilitätsspektrometer und
- Figur 2: eine Ionentransporteinrichtung in perspektivischer Darstellung und
- Figur 3: zwei Seitenwände der Ionentransporteinrichtung gemäß Figur 2 in Draufsicht und
- Figur 4: eine Ionentransporteinrichtung in Transportrichtung betrachtet und
- Figur 5: eine Abschlussplatte in perspektivischer Darstellung und
- Figur 6: die Verbindung zwischen zwei Seitenwänden in vergrößerter Ausschnittsdarstellung.

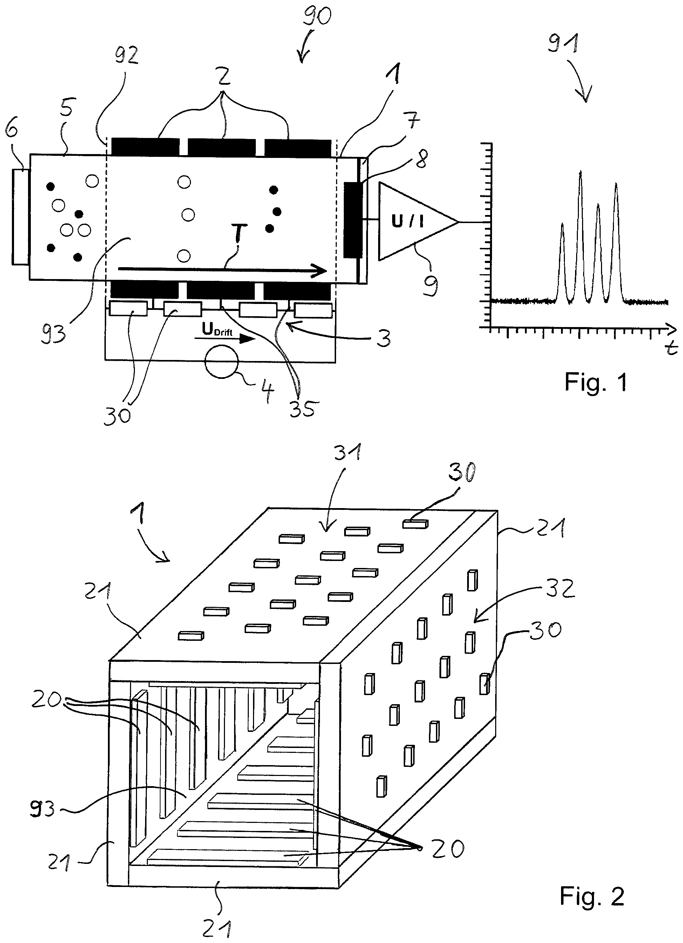

Die Figur 1 zeigt ein IMS 90 in stark vereinfachter schematisierter Darstellung. Das IMS 90 weist einen Ionentransportkanal 1 auf, der bei einem IMS auch als Driftröhre bezeichnet wird. Innerhalb des Ionentransportkanals 1 befindet sich eine Ionentransportkammer 93, durch die Ionen in einer Transportrichtung T von einer Ionenbereitstellungskammer 5 zu einem Ionendetektor 8 bewegt werden können. Um die Ionenbewegung zu erzeugen, weist der Ionentransportkanal 1 Felderzeugungselektroden 2 in Form von Ringelektroden auf, die in Transportrichtung T hintereinander angeordnet sind. Die Felderzeugungselektroden 2 sind über einen Spannungsteiler 3 mit einer elektrischen Energiequelle 4 verbunden. Der Spannungsteiler 3 kann z.B. aus einer Reihenschaltung von Widerständen 30 gebildet sein. Durch diese Anordnung wird ein homogenes elektrisches Feld in Transportrichtung T in der Ionentransportkammer 93 erzeugt.

Die Ionen können in der Ionenbereitstellungskammer 5 beispielsweise durch eine Ionenquelle 6, z.B. eine radioaktive Quelle, bereitgestellt werden. In der Ionenbereitstellungskammer 5 sind sämtliche erzeugten Ionen zunächst noch beliebig miteinander vermischt. Wird ein Messzyklus des IMS 90 gestartet, so werden durch entsprechendes Schalten eines Ionentors 92 Ionen von der Ionenbereitstellungskammer 5 in die Ionentransportkammer 93 eingeleitet. Aufgrund ihrer unterschiedlichen Mobilitäten trennen sich dann die unterschiedlichen Ionenspezies auf ihrem Weg durch die Ionentransportkammer 93 voneinander, sodass unterschiedliche Ionenspezies zu verschiedenen Zeitpunkten am Ionendetektor 8 auftreffen. Der Ionendetektor 8, der z.B. an einer Abschlussplatte 7 angeordnet sein kann, gibt abhängig vom Auftreffen der Ionen elektrische Signale an einen Verstärker 9 ab. Die verstärkten Signale sind in einem Diagramm 91 als lonenmobilitätsspektrum dargestellt. An der Abzissenachse ist die Zeit dargestellt.

Die weiteren Erläuterungen befassen sich nun mit der Frage, wie ein lonentransportkanal 1 bzw. eine damit gebildete Ionentransporteinrichtung besonders günstig hergestellt werden kann.

Die Figur 2 zeigt einen aus Leiterplatten 21 aufgebauten Ionentransportkanal 1. In diesem Fall bilden vier Leiterplatten 21 die Seitenwände des Ionentransportkanals 1. Die Leiterplatten sind an der Innenseite des Ionentransportkanals 1 mit einer ersten Leiterschicht beschichtet. Aus der ersten Leiterschicht sind auf jeder Leiterplatte 21 Leiterbahn-Segmente 20 gebildet, die in Ionentransportrichtung T hintereinander angeordnet sind. Die einzelnen Leiterbahn-Segmente 20 sind mit Spannungsteiler-Anschlusspunkten der jeweiligen Leiterplatte 21 verbunden, z.B. indem Durchkontaktierungen zur gegenüberliegenden Leiterplattenseite vorhanden sind. Auf der gegenüberliegenden Leiterplattenseite, d.h. an der Außenseite des Ionentransportkanals 1, sind Widerstände 30 angeordnet, die einen ersten Spannungsteiler 31 und einen zweiten Spannungsteiler 32 bilden.

Wie man in der Figur 2 erkennt, sind die einzelnen Leiterbahn-Segmente 20, die eine Ringelektrode bilden sollen, nicht in Berührung miteinander und dementsprechend auch nicht galvanisch miteinander verbunden. In diesem Fall wäre es erforderlich, auf der Außenseite jeder Leiterplatte 21 einen entsprechenden Spannungsteiler anzuordnen. Nachfolgend wird noch erläutert, dass in bestimmten Ausführungsformen auch weniger Spannungsteiler eingesetzt werden können, z.B. nur der erste und der zweite Spannungsteiler 31, 32, wie in Figur 2 dargestellt.

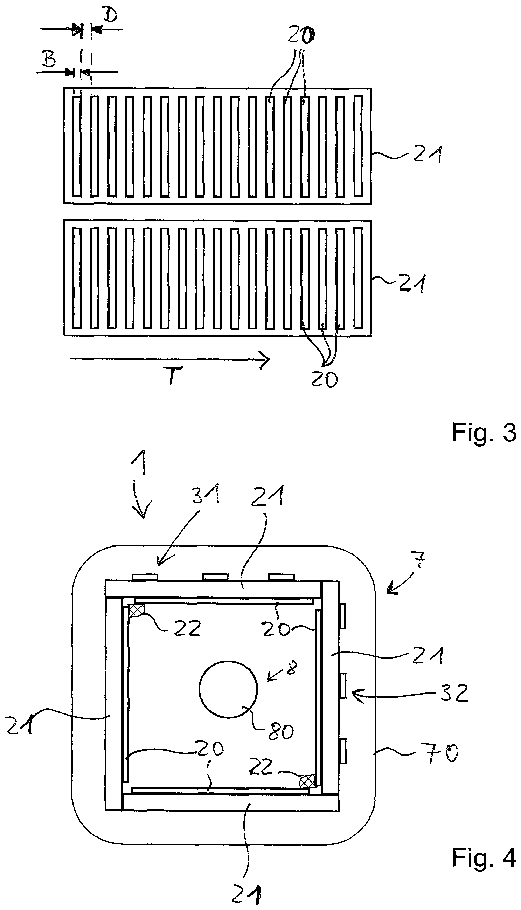

Die Figur 3 zeigt zwei Seitenwände 21 in Draufsicht auf die Innenseite, d.h. die Seite der Leiterplatten 21, an denen die Leiterbahn-Segmente 20 angeordnet sind. Wie erkennbar ist, sind die Leiterbahn-Segmente 20 als schmale Leiterstreifen ausgebildet, die in gleichmäßigen Abständen parallel nebeneinander und in Transportrichtung T gesehen hintereinander angeordnet sind. Ein Leiterbahn-Segment 20 weist dabei eine Breite B auf. Der laterale Abstand zwischen benachbarten Leiterbahn-Segmenten benachbarter Ringelektroden hat das Maß D. Es ist hierbei vorteilhaft, wenn B/D größer 0,5 ist, oder größer 1 ist, oder größer 3 ist.

Die Figur 4 zeigt eine Ionentransporteinrichtung, die einen Ionentransportkanal 1 gemäß der Ausführungsform der Figur 2 aufweist. Zusätzlich ist an einem Ende des Ionentransportkanals 1 eine Abschlussplatte 7 vorhanden, die ebenfalls als Leiterplatte ausgebildet sein kann. Eine Leiterschicht 80 dieser Leiterplatte 70 kann dann den Ionendetektor 8 bilden.

Die Figur 4 zeigt zudem, dass über elektrische Brücken 22 jeweils eine galvanische Verbindung zwischen zwei über Eck angeordneten Leiterbahn-Segmenten 20 derselben Ringelektrode hergestellt sein kann. Weiterhin ist auch eine elektrische Kontaktierung zwischen zwei Leiterbahn-Segmenten außerhalb des Ionentransportkanals möglich. Auf diese Weise kann beispielsweise der erste Spannungsteiler 31 der oberen und der linken Leiterplatte 21 zugeordnet sein, der zweite Spannungsteiler 32 kann der rechten und der unteren Leiterplatte 21 zugeordnet sein. Die galvanischen Verbindungen können z.B. als Lötungen 22 ausgebildet sein.

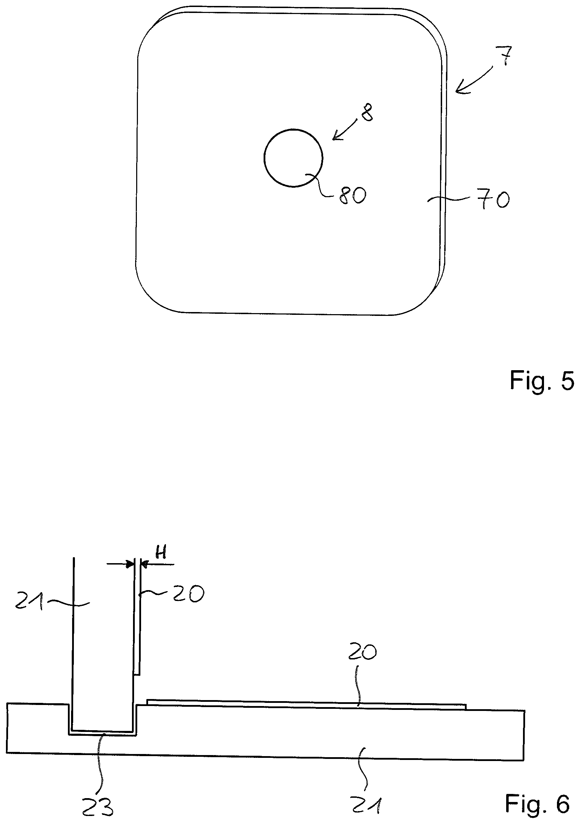

Die Figur 5 zeigt noch einmal die Leiterplatte 70 mit der Leiterschicht 80 in Einzelteildarstellung. Die Leiterschicht 80 kann den Ionendetektor 8 bilden. Die Leiterplatte 70 bildet die Abschlussplatte 7.

Die Figur 6 zeigt eine vorteilhafte mechanische Verbindung zwischen zwei im Winkel zueinander angeordneten Leiterplatten 21, die jeweils Seitenwände des Ionentransportkanals 1 bilden. So kann in einer Leiterplatte 21 eine Nut 23 eingebracht sein. In diese Nut 23 ist eine Endkante einer anderen Leiterplatte 21 eingesetzt. Diese Verbindungsstelle kann beispielsweise durch Klebstoff zusätzlich fixiert sein. Auf diese Weise können sämtliche Seitenwände des Ionentransportkanals 1 miteinander verbunden sein.

Die Figur 6 zeigt zudem das Maß H, das die Höhe der Leiterschicht, die ein Leiterbahn-Segment 20 bildet, definiert (Dicke der Leiterschicht). Es ist vorteilhaft, wenn B/H größer 1 ist, insbesondere größer 5 ist.

## Patentansprüche

1. Ionentransporteinrichtung, die zum Transport von Ionen mittels eines elektrischen Feldes eingerichtet ist, wobei die Ionentransporteinrichtung einen Ionentransportkanal (1) aufweist, in dem eine Ionentransportkammer (93) gebildet ist, wobei der Ionentransportkanal (1) zur Erzeugung des elektrischen Feldes eine Vielzahl von Felderzeugungselektroden (2) aufweist, die entlang der Längserstreckung des Ionentransportkanals (1) hintereinander angeordnet sind, um Ionen in einer Transportrichtung (T) durch die Ionentransportkammer (93) zu bewegen, wobei
a) der Ionentransportkanal (1) weist mehrere aus ebenen Platten gebildete Seitenwände auf, die die Ionentransportkammer (93) umgeben,
b) die Seitenwände sind aus mit wenigstens einer ersten Leiterschicht beschichteten elektrischen Leiterplatten (21) gebildet,
c) die Felderzeugungselektroden (2) sind als unterbrochene Ringelektroden ausgebildet, die die Ionentransportkammer (93) umfangsseitig umgeben, wobei eine, mehrere oder alle der Ringelektroden jeweils aus einzelnen, auf den Leiterplatten (21) durch einen Teil der ersten Leiterschicht gebildeten Leiterbahn-Segmenten (20) zusammengesetzt sind, wobei Leiterbahn-Segmente (20) einer Ringelektrode sich elektrisch kontaktieren können, aber nicht notwendigerweise elektrisch kontaktieren müssen,
d) die Ionentransporteinrichtung weist wenigstens einen ersten Spannungsteiler (31) mit einer Vielzahl von Spannungsteiler-Anschlusspunkten (35) und wenigstens einen zweiten Spannungsteiler (32) mit einer Vielzahl von Spannungsteiler-Anschlusspunkten (35) auf,
e) wobei für eine, mehrere oder alle der Ringelektroden gilt:
e1) wenigstens ein Leiterbahn-Segment (20) der Ringelektrode ist an einen Spannungsteiler-Anschlusspunkt (35) des ersten Spannungsteilers (31) angeschlossen,
e2 ) wenigstens ein anderes Leiterbahn-Segment (20) der Ringelektrode als das Leiterbahn-Segment (20), das an den Spannungsteiler-Anschlusspunkt (35) des ersten Spannungsteilers (31) angeschlossen ist, ist an einen Spannungsteiler-Anschlusspunkt (35) des zweiten Spannungsteilers (32) angeschlossen.

2. Ionentransporteinrichtung nach Anspruch 1, **dadurch gekennzeichnet, dass** eine, mehrere oder alle Seitenwände wenigstens eine parallel zur ersten Leiterschicht verlaufende zweite Leiterschicht der elektrischen Leiterplatte (20) aufweisen.

3. Ionentransporteinrichtung nach Anspruch 2, **dadurch gekennzeichnet, dass** der erste und/oder der zweite Spannungsteiler (31, 32) auf der zweiten Leiterschicht angeordnet ist.

4. Ionentransporteinrichtung nach einem der vorhergehenden Ansprüche, **dadurch gekennzeichnet, dass** der erste Spannungsteiler (31) mehreren Seitenwänden und/oder der zweite Spannungsteiler (32) mehreren Seitenwänden zugeordnet ist.

5. Ionentransporteinrichtung nach einem der vorhergehenden Ansprüche, **dadurch gekennzeichnet, dass** der erste Spannungsteiler (31) einer ersten Seitenwand und/oder der zweite Spannungsteiler (32) einer zweiten Seitenwand zugeordnet ist.

6. Ionentransporteinrichtung nach einem der vorhergehenden Ansprüche, **dadurch gekennzeichnet, dass** jeder aus einer Leiterplatte (20) gebildeten Seitenwand ein eigener Spannungsteiler (31, 32) zugeordnet ist.

7. Ionentransporteinrichtung nach einem der vorhergehenden Ansprüche, **dadurch gekennzeichnet, dass** die Ionentransporteinrichtung ein Netzwerk von Koppelkondensatoren aufweist, durch das die Ringelektroden mit einer elektrischen Signalquelle verbindbar sind, wobei einer, mehrere oder alle der Koppelkondensatoren durch Teile von Leiterschichten einer oder mehrerer aus einer Leiterplatte (20) gebildeten Seitenwänden gebildet sind.

8. Ionentransporteinrichtung nach einem der vorhergehenden Ansprüche, **dadurch gekennzeichnet, dass** die Ionentransporteinrichtung wenigstens einen Heizdraht zum Aufheizen des Ionentransportkanals (1) aufweist, wobei der Heizdraht durch Teile von Leiterschichten einer oder mehrerer aus einer Leiterplatte (20) gebildeten Seitenwänden gebildet ist.

9. Ionentransporteinrichtung nach einem der vorhergehenden Ansprüche, **dadurch gekennzeichnet, dass** ein Teil oder alle der Felderzeugungselektroden auf den Innenlagen der Leiterplatten realisiert wird.

10. Ionentransporteinrichtung nach einem der vorhergehenden Ansprüche, **dadurch gekennzeichnet, dass** die Ionentransporteinrichtung einen Ionendetektor (8) aufweist, der an einem Ende des Ionentransportkanals (93) angeordnet ist, wobei der Ionendetektor (8) durch eine Leiterschicht (80) einer Leiterplatte (70) oder durch ein geätztes Metallgitter, das durch wenigstens eine Leiterplatte sowohl mechanisch fixiert als auch elektrisch kontaktiert ist, gebildet ist.

11. Ionentransporteinrichtung nach einem der vorhergehenden Ansprüche, **dadurch gekennzeichnet, dass** die Ionentransporteinrichtung an mindestens einem Ende des Ionentransportkanals (1) oder der Ionentransportkammer (93) ein Ionentor (92) aufweist, wobei zumindest eine Elektrode des Ionentors (92) durch eine Leiterschicht einer Leiterplatte oder durch ein geätztes Metallgitter, das durch wenigstens eine Leiterplatte sowohl mechanisch fixiert als auch elektrisch kontaktiert ist, gebildet ist.

12. Ionentransporteinrichtung nach einem der vorhergehenden Ansprüche, **dadurch gekennzeichnet, dass** wenigstens eine der Leiterplatten wenigstens eine nutartige Aussparung (23) aufweist, in die wenigstens eine andere Leiterplatte formschlüssig eingesetzt ist.

13. Ionentransporteinrichtung nach einem der vorhergehenden Ansprüche, **dadurch gekennzeichnet, dass** die durch Leiterbahnen-Segmente (20) gebildeten Ringelektroden als mehreckige Ringelektroden ausgebildet sind, deren Anzahl der Ecken der Anzahl der Seitenwände entspricht.

14. Ionentransporteinrichtung nach einem der vorhergehenden Ansprüche, **dadurch gekennzeichnet, dass** das Verhältnis von Breite (B) zu Höhe (H) eines Leiterbahn-Segments (20) einer Ringelektrode größer 1 ist, insbesondere größer 5 ist.

15. Ionentransporteinrichtung nach einem der vorhergehenden Ansprüche, **dadurch gekennzeichnet, dass** das Verhältnis von Breite (B) zu lateralem Abstand (D) von benachbarten Leiterbahn-Segmenten (20) benachbarter Ringelektroden größer 0,5 ist, insbesondere größer 1 oder größer 3 ist.

16. Ionentransporteinrichtung nach einem der vorhergehenden Ansprüche, **dadurch gekennzeichnet, dass** die Ionentransporteinrichtung in Transportrichtung (T) in Segmente segmentiert ist.

17. Ionentransporteinrichtung nach Anspruch 16, **dadurch gekennzeichnet, dass** eines, mehrere oder alle Segmente der Ionentransporteinrichtung jeweils von wenigstens einer senkrecht zur Transportrichtung (T) angeordneten Abschlussplatte (70) abgeschlossen ist, die als Leiterplatte ausgebildet ist.

18. Ionentransporteinrichtung nach Anspruch 17, **dadurch gekennzeichnet, dass** eine, mehrere oder alle Abschlussplatten (70) in Umfangsrichtung über wenigstens eine der Seitenwände hinausragen.

19. Ionentransporteinrichtung nach einem der Ansprüche 16 bis 18, **dadurch gekennzeichnet, dass** zwischen benachbarten Segmenten der lonentransporteinrichtung wenigstens eine Elektrode angeordnet ist, die durch eine Leiterschicht einer Leiterplatte oder durch ein geätztes Metallgitter, das durch wenigstens eine Leiterplatte sowohl mechanisch fixiert als auch elektrisch kontaktiert ist, gebildet ist.

20. Ionentransporteinrichtung nach einem der vorhergehenden Ansprüche, **dadurch gekennzeichnet, dass** die Seitenwände auf die Ionentransportkammer (93) gasdicht umgeben.

21. lonenmobilitätsspektrometer, **gekennzeichnet durch** eine Ionentransporteinrichtung nach einem der vorhergehenden Ansprüche.

22. Ionentrichter, **gekennzeichnet durch** eine Ionentransporteinrichtung nach einem der Ansprüche 1-20.

## Claims

1. Ion transport device adapted to transport ions by means of an electric field, said ion transport device comprising an ion transport channel (1) in which an ion transport chamber (93) is formed, wherein the ion transport channel (1) comprises a plurality of field generating electrodes (2) arranged in series along the longitudinal extension of the ion transport channel (1) for generating the electric field to move ions in a transport direction (T) through the ion transport chamber (93), wherein:
a) the ion transport channel (1) has a plurality of side walls formed of planar plates surrounding the ion transport chamber (93),
b) the side walls are formed of electrical conductor plates (21) coated with at least a first conductor layer,
c) the field generating electrodes (2) are formed as interrupted ring electrodes which surround the ion transport chamber (93) peripherally, wherein one, several or all of the ring electrodes are each composed of individual conductor track segments (20) formed on the conductor plates (21) by a part of the first conductor layer, wherein conductor track segments (20) of a ring electrode can make electrical contact with one another but do not necessarily have to make electrical contact,
d) the ion transport device comprises at least one first voltage divider (31) having a plurality of voltage divider connection points (35) and at least one second voltage divider (32) having a plurality of voltage divider connection points (35),
e) wherein for one, more or all of the ring electrodes:
e1) at least one conductor track segment (20) of the ring electrode is connected to a voltage divider connection point (35) of the first voltage divider (31),
e2) at least one conductor track segment (20) of the ring electrode other than the conductor track segment (20) connected to the voltage divider terminal point (35) of the first voltage divider (31) is connected to a voltage divider connection point (35) of the second voltage divider (32).

2. Ion transport device according to claim 1, **characterized in that** one, several or all side walls comprise at least one second conductor layer of the electrical circuit board (20) extending parallel to the first conductor layer.

3. Ion transport device according to claim 2, **characterized in that** the first and/or the second voltage divider (31, 32) is arranged on the second conductor layer.

4. Ion transport device according to one of the preceding claims, **characterized in that** the first voltage divider (31) is assigned to a plurality of side walls and/or the second voltage divider (32) is assigned to a plurality of side walls.

5. Ion transport device according to one of the preceding claims, **characterized in that** the first voltage divider (31) is associated with a first side wall and/or the second voltage divider (32) is associated with a second side wall.

6. Ion transport device according to one of the preceding claims, **characterized in that** each side wall formed by an electrical conductor plate (20) is assigned its own voltage divider (31, 32).

7. Ion transport device according to any one of the preceding claims, **characterized in that** the ion transport device comprises a network of coupling capacitors by which the ring electrodes are connectable to an electrical signal source, wherein one, several or all of the coupling capacitors are formed by parts of conductor layers of one or more side walls formed of an electrical conductor plate (20).

8. Ion transport device according to any one of the preceding claims, **characterized in that** the ion transport device comprises at least one heating wire for heating the ion transport channel (1), the heating wire being formed by parts of conductor layers of one or more side walls formed of an electrical conductor plate (20).

9. Ion transport device according to any one of the preceding claims, **characterized in that** part or all of the field generating electrodes are realized on the inner layers of the electrical conductor plates.

10. Ion transport device according to any one of the preceding claims, **characterized in that** the ion transport device comprises an ion detector (8) arranged at one end of the ion transport channel (93), the ion detector (8) being formed by a conductor layer (80) of an electrical conductor plate (70) or by an etched metal grid which is both mechanically fixed and electrically contacted by at least one conductor plate.

11. Ion transport device according to any one of the preceding claims, **characterized in that** the ion transport device comprises an ion gate (92) at at least one end of the ion transport channel (1) or the ion transport chamber (93), wherein at least one electrode of the ion gate (92) is formed by a conductor layer of an electrical conductor plate or by an etched metal grid which is both mechanically fixed and electrically contacted by at least one electrical conductor plate.

12. Ion transport device according to one of the preceding claims, **characterized in that** at least one of the electrical conductor plates has at least one groove-like recess (23) into which at least one other electrical conductor plate is inserted in a form-fitting manner.

13. Ion transport device according to one of the preceding claims, **characterized in that** the ring electrodes formed by conductor track segments (20) are designed as polygonal ring electrodes, the number of corners of which corresponds to the number of side walls.

14. Ion transport device according to one of the preceding claims, **characterized in that** the ratio of width (B) to height (H) of a conductor track segment (20) of a ring electrode is greater than 1, in particular greater than 5.

15. Ion transport device according to one of the preceding claims, **characterized in that** the ratio of width (B) to lateral distance (D) of adjacent conductor track segments (20) of adjacent ring electrodes is greater than 0.5, in particular greater than 1 or greater than 3.

16. Ion transport device according to any one of the preceding claims, **characterized in that** the ion transport device is segmented into segments in the transport direction (T).

17. Ion transport device according to claim 16, **characterized in that** one, several or all segments of the ion transport device are each terminated by at least one termination plate (70) arranged perpendicular to the transport direction (T), which termination plate is designed as an electrical conductor plate.

18. Ion transport device according to claim 17, **characterized in that** one, several or all of the termination plates (70) protrude in the circumferential direction beyond at least one of the side walls.

19. Ion transport device according to any one of claims 16 to 18, **characterized in that** between adjacent segments of the ion transport device at least one electrode is arranged which is formed by a lead layer of an electrical conductor plate or by an etched metal grid which is both mechanically fixed and electrically contacted by at least one electrical conductor plate.

20. Ion transport device according to any one of the preceding claims, **characterized in that** the side walls surround the ion transport chamber (93) in a gas-tight manner.

21. Ion mobility spectrometer, **characterized by** an ion transport device according to any one of the preceding claims.

22. Ion funnel, **characterized by** an ion transport device according to any one of claims 1 to 20.

## Revendications

1. Dispositif de transport d'ions conçu pour transporter des ions au moyen d'un champ électrique, le dispositif de transport d'ions comprenant un canal de transport d'ions (1) dans lequel est formée une chambre de transport d'ions (93), le canal de transport d'ions (1) comprenant, pour la génération du champ électrique, une pluralité d'électrodes de génération de champ (2) qui sont disposées les unes derrière les autres le long de l'extension longitudinale du canal de transport d'ions (1), afin de transporter des ions dans une direction de transport (T) à travers la chambre de transport d'ions (93),
dans lequel
a) le canal de transport d'ions (1) présente plusieurs parois latérales formées par des plaques planes qui entourent la chambre de transport d'ions (93),
b) les parois latérales sont formées par des cartes de circuit électriques (21) revêtues d'au moins une première couche conductrice,
c) les électrodes de génération de champ (2) sont réalisées sous forme d'électrodes annulaires interrompues qui entourent la chambre de transport d'ions (93) sur sa périphérie, une, plusieurs ou toutes les électrodes annulaires étant composées chacune de segments de piste conductrice (20) individuels formés sur les cartes de circuit (21) par une partie de la première couche conductrice, les segments de piste conductrice (20) d'une électrode annulaire pouvant être en contact électrique, mais ne devant pas nécessairement être en contact électrique,
d) le dispositif de transport d'ions comprend au moins un premier diviseur de tension (31) avec une pluralité de points de connexion de diviseur de tension (35) et au moins un deuxième diviseur de tension (32) avec une pluralité de points de connexion de diviseur de tension (35),
e) sachant que pour une, plusieurs ou toutes les électrodes annulaires
e1) au moins un segment de piste conductrice (20) de l'électrode annulaire est connecté à un point de connexion de diviseur de tension (35) du premier diviseur de tension (31),
e2) au moins un segment de piste conductrice (20) de l'électrode annulaire, autre que le segment de piste conductrice (20) connecté au point de connexion de diviseur de tension (35) du premier diviseur de tension (31), est connecté à un point de connexion de diviseur de tension (35) du deuxième diviseur de tension (32).

2. Dispositif de transport d'ions selon la revendication 1,
**caractérisé en ce qu'**une, plusieurs ou toutes les parois latérales présentent au moins une deuxième couche conductrice de la carte de circuit électrique (20) s'étendant parallèlement à la première couche conductrice.

3. Dispositif de transport d'ions selon la revendication 2,
**caractérisé en ce que** le premier et/ou le deuxième diviseur de tension (31, 32) est disposé sur la deuxième couche conductrice.

4. Dispositif de transport d'ions selon l'une des revendications précédentes, **caractérisé en ce que** le premier diviseur de tension (31) est associé à plusieurs parois latérales et/ou le deuxième diviseur de tension (32) est associé à plusieurs parois latérales.

5. Dispositif de transport d'ions selon l'une des revendications précédentes, **caractérisé en ce que** le premier diviseur de tension (31) est associé à une première paroi latérale et/ou le deuxième diviseur de tension (32) est associé à une deuxième paroi latérale.

6. Dispositif de transport d'ions selon l'une des revendications précédentes, **caractérisé en ce qu'**un diviseur de tension (31, 32) propre est associé à chaque paroi latérale formée d'une carte de circuit (20).

7. Dispositif de transport d'ions selon l'une des revendications précédentes, **caractérisé en ce que** le dispositif de transport d'ions présente un réseau de condensateurs de couplage par lequel les électrodes annulaires peuvent être reliées à une source de signaux électrique, un, plusieurs ou tous les condensateurs de couplage étant formés par des parties de couches conductrices d'une ou plusieurs parois latérales formées par une carte de circuit (20).

8. Dispositif de transport d'ions selon l'une des revendications précédentes, **caractérisé en ce que** le dispositif de transport d'ions comprend au moins un fil chauffant pour chauffer le canal de transport d'ions (1), le fil chauffant étant formé par des parties de couches conductrices d'une ou de plusieurs parois latérales formées par une carte de circuit (20).

9. Dispositif de transport d'ions selon l'une des revendications précédentes, **caractérisé en ce qu'**une partie ou la totalité des électrodes de génération de champ est réalisée sur les couches internes des cartes de circuit.

10. Dispositif de transport d'ions selon l'une des revendications précédentes,
**caractérisé en ce que** le dispositif de transport d'ions comprend un détecteur d'ions (8) disposé à une extrémité du canal de transport d'ions (93), le détecteur d'ions (8) étant formé par une couche conductrice (80) d'une carte de circuit (70) ou par une grille métallique gravée qui est à la fois fixée mécaniquement et mise en contact électrique par au moins une carte de circuit.

11. Dispositif de transport d'ions selon l'une des revendications précédentes,
**caractérisé en ce que** le dispositif de transport d'ions présente une porte à ions (92) à au moins une extrémité du canal de transport d'ions (1) ou de la chambre de transport d'ions (93), au moins une électrode de la porte à ions (92) étant formée par une couche conductrice d'une carte de circuit ou par une grille métallique gravée qui est à la fois fixée mécaniquement et mise en contact électrique par au moins une carte de circuit.

12. Dispositif de transport d'ions selon l'une des revendications précédentes,
**caractérisé en ce qu'**au moins l'une des cartes de circuit présente au moins un évidement (23) en forme de rainure, dans lequel au moins une autre carte de circuit est insérée par complémentarité de forme.

13. Dispositif de transport d'ions selon l'une des revendications précédentes,
**caractérisé en ce que** les électrodes annulaires formées par des segments de piste conductrice (20) sont conçues comme des électrodes annulaires polygonales dont le nombre de coins correspond au nombre de parois latérales.

14. Dispositif de transport d'ions selon l'une des revendications précédentes,
**caractérisé en ce que** le rapport entre la largeur (B) et la hauteur (H) d'un segment de piste conductrice (20) d'une électrode annulaire est supérieur à 1, en particulier supérieur à 5.

15. Dispositif de transport d'ions selon l'une des revendications précédentes,
**caractérisé en ce que** le rapport entre la largeur (B) et la distance latérale (D) de segments de piste conductrice (20) voisins d'électrodes annulaires voisines est supérieur à 0,5, en particulier supérieur à 1 ou supérieur à 3.

16. Dispositif de transport d'ions selon l'une des revendications précédentes,
**caractérisé en ce que** le dispositif de transport d'ions est segmenté en segments dans la direction de transport (T).

17. Dispositif de transport d'ions selon la revendication 16,
**caractérisé en ce qu'**un, plusieurs ou tous les segments du dispositif de transport d'ions sont chacun fermés par au moins une plaque de fermeture (70) disposée perpendiculairement à la direction de transport (T), qui est conçue comme une carte de circuit.

18. Dispositif de transport d'ions selon la revendication 17,
**caractérisé en ce qu'**une, plusieurs ou toutes les plaques de fermeture (70) dépassent dans la direction périphérique au-delà d'au moins une des parois latérales.

19. Dispositif de transport d'ions selon l'une des revendications 16 à 18,
**caractérisé en ce qu'**entre des segments voisins du dispositif de transport d'ions est disposée au moins une électrode qui est formée par une couche conductrice d'une carte de circuit ou par une grille métallique gravée qui est à la fois fixée mécaniquement et mise en contact électrique par au moins une carte de circuit.

20. Dispositif de transport d'ions selon l'une des revendications précédentes,
**caractérisé en ce que** les parois latérales entourent la chambre de transport d'ions (93) de manière étanche aux gaz.

21. Spectromètre de mobilité ionique,
**caractérisé par** un dispositif de transport d'ions selon l'une des revendications précédentes.

22. Entonnoir à ions,
**caractérisé par** un dispositif de transport d'ions selon l'une des revendications 1 à 20.
